(19) Europäisches Patentamt
European Patent Office
Office européen des brevets

(11) **EP 4 361 099 A1**

(12) **EUROPEAN PATENT APPLICATION**

(43) Date of publication:
**01.05.2024 Bulletin 2024/18**

(21) Application number: **23205035.1**

(22) Date of filing: **20.10.2023**

(51) International Patent Classification (IPC):
**C01B 32/162** (2017.01)   **B01J 23/74** (2006.01)
**B01J 23/84** (2006.01)   **H01M 10/00** (2006.01)

(52) Cooperative Patent Classification (CPC):
**C01B 32/162; B01J 23/74; B01J 23/84;
H01M 10/00;** C01B 32/174; C01B 2202/08;
C01B 2202/22; C01B 2202/30; C01B 2202/32;
C01B 2202/34; C01B 2202/36; C01P 2006/10

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **21.10.2022 KR 20220136551**

(71) Applicant: **Korea Kumho Petrochemical Co., Ltd.
Seoul 04542 (KR)**

(72) Inventors:
• **LEE, Wan Sung**
**34048 Daejeon (KR)**
• **KIM, Hyun Tae**
**04369 Seoul (KR)**
• **RYU, Sang Hyo**
**04720 Seoul (KR)**
• **JEONG, Chung Heon**
**34061 Daejeon (KR)**
• **JEONG, Myung Hoon**
**28630 Cheongju-si, Chungcheongbuk-do (KR)**
• **JUNG, Woo Ram**
**34049 Daejeon (KR)**
• **KANG, Chang Gu**
**34011 Daejeon (KR)**

(74) Representative: **Beck & Rössig
European Patent Attorneys
Denninger Str. 169
81925 München (DE)**

(54) **PREPARING METHOD FOR LOW-DIAMETER CARBON NANOTUBE AND CARBON NANOTUBE PREPARED BY THE METHOD**

(57)   A method for preparing a carbon nanotube, comprises: (a) introducing a catalyst into a chemical vapor deposition reactor; and (b) injecting a carbon source gas to synthesize a carbon nanotube, wherein an input of the catalyst and a flow rate of the carbon source gas satisfy the following Formula 1:

[Formula 1]

$$0.1 \text{ L/g·min} \le a/b \le 1.1 \text{ L/g·min}$$

wherein a represents a flow rate (L/min) of the carbon source gas and b represents an input (g) of the catalyst. Further disclosed is a carbon nanotube prepared by the method.

(a) Example 1   (b) Example 4

(c) Comparative Example 2

**FIG. 1**

**Description**

**Technical field**

The present invention relates to a method for preparing a low-diameter carbon nanotube and a carbon nanotube prepared by the method.

**Background art**

As the interest and demand for eco-friendly energy and electric vehicles are on the rise, the demand for a secondary battery and the necessity for improving the performance thereof are rapidly increasing. Especially, the secondary battery for electric vehicles is required to be a high-capacity secondary battery with a high energy density, a long lifespan and a low self-discharge rate. In order to secure such physical properties, it is essential to develop conductive materials with high electrical conductivity.

As a conductive material which serves as a passage of electric charges inside the battery, a carbon-based conductive material, for example, graphite, carbon black, graphene, carbon nanotubes, etc. may be used. Conventionally, conductive carbon black was mainly used.

A carbon nanotube is a material having a tube-type structure formed in a hexagonal hive-shaped lattice in which one carbon atom is bonded to three other carbon atoms. Due to its excellent electrical conductivity, carbon nanotube is spotlighted as a next-generation conductive material for the secondary battery. When carbon nanotube is used as a conductive material, the energy density and lifespan characteristics of the secondary battery may be improved, thereby reducing the size of the battery.

Meanwhile, as the carbon nanotube has a smaller diameter, it exhibits more excellent electrical conductivity. Therefore, the use of a low-diameter carbon nanotube as a conductive material for a secondary battery may further improve the capacity and lifespan characteristics of the secondary battery. Accordingly, there is a demand for developing a technology for preparing a carbon nanotube having a smaller diameter than that of a conventional carbon nanotube, with a high purity.

**Summary of invention**

**Technical task**

The description of the present specification is intended to solve the problems of the prior art described above. It is an object of the present specification to provide a method for preparing a carbon nanotube capable of synthesizing a low-diameter carbon nanotube with a high purity.

It is another object of the present specification to provide a low-diameter carbon nanotube with excellent electrical conductivity.

**Means for solving technical task**

According to an aspect, the present specification provides a method for preparing a carbon nanotube, comprising: (a) introducing a catalyst into a chemical vapor deposition reactor; and (b) injecting a carbon source gas to synthesize a carbon nanotube, wherein an input of the catalyst and a flow rate of the carbon source gas satisfy the following Formula 1:

$$[\text{Formula } 1]$$

$$0.1 \ \text{L/g·min} \leq a/b \leq 1.1 \ \text{L/g·min}$$

wherein a represents a flow rate (L/min) of the carbon source gas and b represents an input (g) of the catalyst.

In a preferred embodiment, the catalyst may comprise a main catalyst and a support, and a mole fraction of the main catalyst to the support may be 0.01 to 0.5.

In a preferred embodiment, the catalyst may comprise: i) one main catalyst selected from the group consisting of Co, Fe, Ni and combinations thereof; ii) one support selected from the group consisting of Al, Ca, Mg and combinations thereof; and iii) one cocatalyst selected from the group consisting of V, Mn, Mo and combinations thereof.

In a preferred embodiment, the carbon source gas may comprise one selected from the group consisting of unsaturated or saturated hydrocarbon having 1 to 4 carbon atoms, carbon monoxide and mixtures of two or more thereof.

According to another aspect, the present specification provides a carbon nanotube prepared by the method for preparing a carbon nanotube described above.

In a preferred embodiment, the carbon nanotube may have a diameter of 7 to 12 nm.

In a preferred embodiment, the carbon nanotube may have a purity of 90% or more.

In a preferred embodiment, the carbon nanotube may have a bundle length of 50 to 200 $\mu$m.

In a preferred embodiment, the carbon nanotube may have a BET specific surface area of 250 to 400 m$^2$/g.

In a preferred embodiment, the carbon nanotube may have a bulk density of 0.005 to 0.5 g/ml.

**Effect of invention**

The method for preparing a carbon nanotube according to an aspect of the present specification may synthesize, with a high purity, a low-diameter carbon nanotube having a diameter smaller than that of a conventional carbon nanotube.

Also, the carbon nanotube according to another aspect of the present specification has a small diameter and thus has excellent electrical conductivity, thereby improving capacity and lifespan characteristics of a secondary battery when used as a conductive material for a secondary battery.

The effects of the present specification are not limited to the above-mentioned effects, and it should be understood that the effects of the present specification include all effects that could be inferred from the configuration described in the detailed description of the specification or the appended claims.

**Brief description of drawings**

Fig. 1 illustrates TEM images of carbon nanotubes synthesized according to Examples or Comparative Examples of the present specification;

Fig. 2 illustrates analysis results of the diameters of carbon nanotubes synthesized according to Examples or Comparative Examples of the present specification; and

Fig. 3 illustrates SEM images of carbon nanotubes synthesized according to Examples or Comparative Examples of the present specification.

**Best mode for carrying out the invention**

Hereinafter, an aspect of the present specification will be explained with reference to the accompanying drawing. The description of the present specification, however, may be modified in different ways, and should not be construed as limited to the embodiments set forth herein. Also, in order to clearly explain an aspect of the present specification in the drawing, portions that are not related to the explanation are omitted, and like reference numerals are used to refer to like elements throughout the specification.

Throughout the specification, it should be understood that when a portion is referred to as being "connected" to another portion, it can be "directly connected to" the other portion, or "indirectly connected to" the other portion having intervening portions present. Also, when a component "includes" an element, unless there is another opposite description thereto, it should be understood that the component does not exclude another element but may further include another element.

When a range of numerical values is described herein, the value has the precision of the significant figures provided according to the standard rules in chemistry for significant figures, unless a specific range thereof is stated otherwise. For example, 10 includes a range of 5.0 to 14.9 and the number 10.0 includes a range of 9.50 to 10.49.

Hereinafter, an embodiment of the present specification will be described in detail with reference to the accompanying drawing.

Method for preparing carbon nanotube

A method for preparing a carbon nanotube according to an aspect of the present specification comprises (a) introducing a catalyst into a chemical vapor deposition reactor; and (b) injecting a carbon source gas to synthesize a carbon nanotube, wherein an input of the catalyst and a flow rate of the carbon source gas satisfy the following Formula 1:

[Formula 1]

$$0.1 \ \text{L/g·min} \leq a/b \leq 1.1 \ \text{L/g·min}$$

wherein a represents a flow rate (L/min) of the carbon source gas and b represents an input (g) of the catalyst.

The method for preparing a carbon nanotube may prepare a low-diameter carbon nanotube having a diameter smaller than that of a conventional carbon nanotube by adjusting a ratio (a/b value) of the flow rate of carbon source gas to the input of catalyst. The carbon nanotube prepared by the above method may have a diameter of 7 to 12 nm, and as the a/b value is smaller, the carbon nanotube prepared may have a smaller diameter.

The a/b value may be, for example, 0.1 L/g min, 0.2 L/g min, 0.3 L/g min, 0.4 L/g min, 0.5 L/g min, 0.6 L/g min, 0.7 L/g min, 0.8 L/g min, 0.9 L/g min, 1.0 L/g min, 1.1 L/g·min or a range between any two of these values. When the a/b value is less than the above range, catalytic activity may be too low to synthesize a carbon nanotube. When the a/b value exceeds the above range, the synthesized carbon nanotube may have a greater diameter and decreased electrical conductivity.

The catalyst may comprise i) one main catalyst selected from the group consisting of Co, Fe, Ni and combinations thereof; ii) one support selected from the group consisting of Al, Ca, Mg and combinations thereof; and iii) one cocatalyst selected from the group consisting of V, Mn, Mo and combinations thereof, but is not limited thereto.

A mole fraction of the main catalyst to the support may be 0.01 to 0.5. For example, the mole fraction may be 0.01, 0.02, 0.03, 0.04, 0.05, 0.06, 0.07, 0.08, 0.09, 0.1, 0.11, 0.12, 0.13, 0.14, 0.15, 0.16, 0.17, 0.18, 0.19, 0.2, 0.21, 0.22, 0.23, 0.24, 0.25, 0.26, 0.27, 0.28, 0.29, 0.3, 0.31, 0.32, 0.33, 0.34, 0.35, 0.36, 0.37, 0.38, 0.39, 0.4, 0.41, 0.42, 0.43, 0.44, 0.45, 0.46, 0.47, 0.48, 0.49, 0.5 or a range between any two of these values. When the mole fraction of the main catalyst to the support is less than the above range, the synthesis yield of carbon nanotubes may decrease, and the dispersibility of the carbon nanotubes prepared may decrease. When the mole fraction of the main catalyst to the support exceeds the above range, the content of the support is relatively low, resulting in degradation of durability of the catalyst and decrease in electrical conductivity of the carbon nanotubes prepared.

The catalyst may be prepared by spray pyrolysis or supporting method, but the present specification is not limited thereto.

When the catalyst is prepared by spray pyrolysis, the catalyst may be prepared by the following steps: (a') dissolving precursors of the main catalyst, the support and the cocatalyst in a solvent to prepare a catalyst mixed solution; (b') spraying the catalyst mixed solution into a reactor of a high temperature by gas spraying using a carrier gas of 2 to 5 atmospheres to be subjected to thermal decomposition at a temperature of 600 to 1,200°C to form a catalyst powder; and (c') obtaining the catalyst powder.

The precursor may be nitrate, sulphate, alkoxide and carbonate, but is not limited thereto.

The solvent may be deionized water, but is not limited thereto.

The carrier gas may be air, but is not limited thereto.

The temperature during thermal decomposition may be 600 to 1,200°C, preferably 600 to 1,000°C, but is not limited thereto.

The pressure of the carrier gas during thermal decomposition may be 2 to 5 atmospheres, preferably 2 to 4 atmospheres, but is not limited thereto.

The catalyst prepared by spray pyrolysis may have a bulk density of 0.01 to 0.50 g/mL, preferably 0.03 to 0.40 g/mL.

The catalyst prepared by spray pyrolysis may have a hollow structure. In this case, the hollow structure may have a thickness of 0.5 to 10 $\mu$m, preferably 1 to 8 $\mu$m, and the hollow ratio may be 50 vol % or more. As used herein, the hollow structure refers to a three-dimensional structure that is hollow inside, for example, a spherical or polyhedral structure that is hollow inside, including a closed structure where all of the hollows are enclosed, an open structure where some of the hollows are open, or a combination thereof. If the catalyst has a hollow structure as shown above, it may be advantageous for the synthesis of low-diameter carbon nanotubes.

The chemical vapor deposition reactor may be a fixed-bed chemical vapor deposition reactor or a fluidized-bed chemical vapor deposition reactor, but is not limited thereto.

The carbon source gas may comprise one selected from the group consisting of unsaturated or saturated hydrocarbon having 1 to 4 carbon atoms, carbon monoxide and mixtures of two or more thereof. For example, the carbon source gas may include methane ($CH_4$), ethane ($C_2H_6$), ethylene ($C_2H_4$), propane ($C_3H_8$), butane ($C_4H_{10}$), acetylene ($C_2H_2$), carbon monoxide (CO) or mixtures of two or more thereof, but is not limited thereto.

In step (b), the internal temperature of the chemical vapor deposition reactor may be 600 to 1,000°C. For example, the temperature may be 600°C, 650°C, 700°C, 750°C, 800°C, 850°C, 900°C, 950°C, 1,000°C or a range between any two of these values. When the internal temperature of the reactor is lower than the above range, the growth of carbon nanotubes may be impossible or delayed. When the internal temperature exceeds the above range, the synthesized carbon nanotubes may be pyrolyzed or interconnected with each other, which makes it impossible to maintain the morphology thereof.

In step (b), the carbon source gas may be injected with a carrier gas. The carrier gas may be one selected from the group consisting of helium, nitrogen, argon and mixtures of two or more thereof, but is not limited thereto.

In step (b), a carbon nanotube may be synthesized while the carbon source gas decomposed by heat of a high temperature permeates the catalyst to be saturated, and then carbon is precipitated.

Carbon nanotube

A carbon nanotube according to another aspect of the present specification may be prepared by the method for preparing a carbon nanotube described above.

The carbon nanotube may have a diameter of 7 to 12 nm. For example, the diameter may be 7 nm, 8 nm, 9 nm, 10 nm, 11 nm, 12 nm or a range between any two of these values. When the diameter is less than the above range, the carbon nanotube may have structural defects or degraded dispersibility. When the diameter exceeds the above range, the carbon nanotube may have decreased electrical conductivity, which may reduce the energy density, lifespan characteristics and self-discharge rate of a secondary battery when used as a conductive material for a secondary battery.

The carbon nanotube may have a purity of 90% or more. When the purity is less than the above range, electrical conductivity may decrease, and when the carbon nanotube is used as a conductive material for a secondary battery, impurities react inside the battery, which may cause safety accidents.

The carbon nanotubes may be formed such that a plurality of carbon nanotubes are aggregated into bundles, but are not limited thereto.

The carbon nanotube may have a bundle length of 50 to 200 $\mu$m. For example, the bundle length may be 50 $\mu$m, 60 $\mu$m, 70 $\mu$m, 80 $\mu$m, 90 $\mu$m, 100 $\mu$m, 110 $\mu$m, 120 $\mu$m, 130 $\mu$m, 140 $\mu$m, 150 $\mu$m, 160 $\mu$m, 170 $\mu$m, 180 $\mu$m, 190 $\mu$m, 200 $\mu$m or a range between any two of these values. When the bundle length is less than the above range, electrical conductivity may decrease. When the bundle length exceeds the above range, dispersibility may decrease.

The carbon nanotube may have a BET specific surface area of 250 to 400 $m^2/g$. For example, the BET specific surface area may be 250 $m^2/g$, 260 $m^2/g$, 270 $m^2/g$, 280 $m^2/g$, 290 $m^2/g$, 300 $m^2/g$, 310 $m^2/g$, 320 $m^2/g$, 330 $m^2/g$, 340 $m^2/g$, 350 $m^2/g$, 360 $m^2/g$, 370 $m^2/g$, 380 $m^2/g$, 390 $m^2/g$, 400 $m^2/g$ or a range between any two of these values. When the BET specific surface area is less than the above range, electrical conductivity may decrease. When the BET specific surface area exceeds the above range, dispersibility may decrease. The carbon nanotube may have a bulk density of 0.005 to 0.5 g/ml. For example, the bulk density may be 0.005 g/ml, 0.01 g/ml, 0.02 g/ml, 0.03 g/ml, 0.04 g/ml, 0.05 g/ml, 0.06 g/ml, 0.07 g/ml, 0.08 g/ml, 0.09 g/ml, 0.1 g/ml, 0.2 g/ml, 0.3 g/ml, 0.4 g/ml, 0.5 g/ml or a range between any two of these values. The bulk density may be measured using a carbon nanotube in the form of powder. When the bulk density is less than the above range, dispersibility may decrease. When the bulk density exceeds the above range, electrical conductivity may decrease.

The carbon nanotube exhibits excellent electrical conductivity, and thus may exhibit the same or more improved performance than a conventional carbon nanotube even in a small amount when used as a conductive material for a secondary battery. Accordingly, the carbon nanotube may be applied to the production of a high capacity secondary battery with a high energy density, a long lifespan and a low self-discharge rate.

Hereinafter, examples of the present specification will be described in more detail. However, the following experimental results describe only representative experimental results among the examples and the scope and content of the present specification may not be construed as narrowed or limited by the examples. Each effect of the various embodiments of the present specification not explicitly presented below will be specifically described in the corresponding section.

Preparation Example 1

A precursor mixed solution was prepared by dissolving 0.76 mol of $Co(NO_3)_3 \cdot 6H_2O$, 2.36 mol of $Al(NO_3)_3 \cdot 9H_2O$ and 0.09 mol of $NH_4VO_3$ in deionized water. Afterwards, the precursor mixed solution was sprayed into a reactor of 750°C for pyrolysis to prepare a catalyst.

Preparation Example 2

A precursor mixed solution was prepared by dissolving 0.31 mol of $Co(NO_3)_3 \cdot 6H_2O$, 3.42 mol of $Al(NO_3)_3 \cdot 9H_2O$ and 0.04 mol of $NH_4VO_3$ in deionized water. Afterwards, the precursor mixed solution was sprayed into a reactor of 750°C for pyrolysis to prepare a catalyst.

Preparation Example 3

A precursor mixed solution was prepared by dissolving 0.62 mol of $Co(NO_3)_3 \cdot 6H_2O$, 2.61 mol of $Al(NO_3)_3 \cdot 9H_2O$ and 0.07 mol of $NH_4VO_3$ in deionized water. Afterwards, the precursor mixed solution was sprayed into a reactor of 750°C for pyrolysis to prepare a catalyst.

Preparation Example 4

After preparing a transparent solution by dissolving 0.07 mol of $NH_4VO_3$ and 0.07 mol of $C_6H_8O_7$ in deionized water, 0.8 mol of $Fe(NO_3)_3 \cdot 9H_2O$, 1.65 mol of $Al(NO_3)_3 \cdot 9H_2O$ and 0.78 mol of $Mg(NO_3)_2 \cdot 6H_2O$ were additionally dissolved therein to prepare a precursor mixed solution. Afterwards, the precursor mixed solution was sprayed into a reactor of 750°C for pyrolysis to prepare a catalyst.

Examples 1 to 7 and Comparative Examples 1 to 3

The catalysts prepared in Preparation Examples 1 to 4 were introduced into a fluidized-bed chemical vapor deposition reactor 350 mm, the internal temperature of the reactor was raised to 650 to 800°C under nitrogen atmosphere, and a carbon source gas was injected to synthesize carbon nanotubes. In this case, the carbon source gas was injected according to a ratio (a/b value) of the flow rate of carbon source gas to the input of catalyst in Table 1 below, and the total amount of the injected carbon source gas was equally maintained.

Table 1 below shows the type of catalyst used in Examples 1 to 7 and Comparative Examples 1 to 3, the mole fraction of main catalyst to support, and the ratio of the flow rate of carbon source gas to the input of catalyst.

[Table 1]

|  | Catalyst | Main catalyst/support (mole fraction) | a/b (L/g·min) |
|---|---|---|---|
| Example 1 | Preparation Example 1 | 0.32 | 0.13 |
| Example 2 | Preparation Example 1 | 0.32 | 0.3 |
| Example 3 | Preparation Example 1 | 0.32 | 0.52 |
| Example 4 | Preparation Example 1 | 0.32 | 0.94 |
| Example 5 | Preparation Example 2 | 0.09 | 0.3 |
| Example 6 | Preparation Example 3 | 0.24 | 0.52 |
| Example 7 | Preparation Example 4 | 0.33 | 0.82 |
| Comparative Example 1 | Preparation Example 1 | 0.32 | 0.08 |
| Comparative Example 2 | Preparation Example 1 | 0.32 | 1.2 |
| Comparative Example 3 | Preparation Example 4 | 0.33 | 1.3 |
| * a = flow rate (L/min) of carbon source gas<br>* b = input (g) of catalyst | | | |

Experimental Example 1

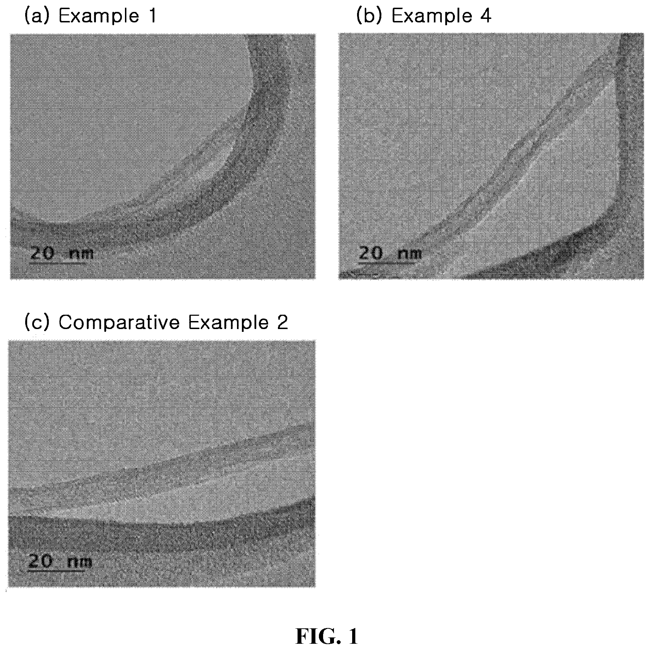

The catalyst yield, purity, and structural characteristics of carbon nanotubes synthesized according to Examples and Comparative Examples described above were analyzed, and the results thereof were shown in Table 2 below and Figs. 1 to 3.

1) Catalyst yield: The catalyst yield means the total amount of carbon nanotubes synthesized relative to the input of catalyst, and was calculated according to the following equation.

$$\text{Catalyst yield (\%)} = \text{total amount (g) of synthesized carbon nanotubes/input (g) of}$$

$$\text{catalyst} \times 100$$

2) Purity: After combusting carbon nanotubes at 800°C using a thermal oxidation furnace, the purity was calculated according to the following equation using the weight of carbon nanotubes introduced and the weight of carbon nanotubes after the combustion.

$$\text{Purity (\%) of carbon nanotubes} = [(\text{weight of carbon nanotubes introduced} - \text{weight}$$

$$\text{of carbon nanotubes after combustion})/\text{weight of carbon nanotubes introduced}] \times 100$$

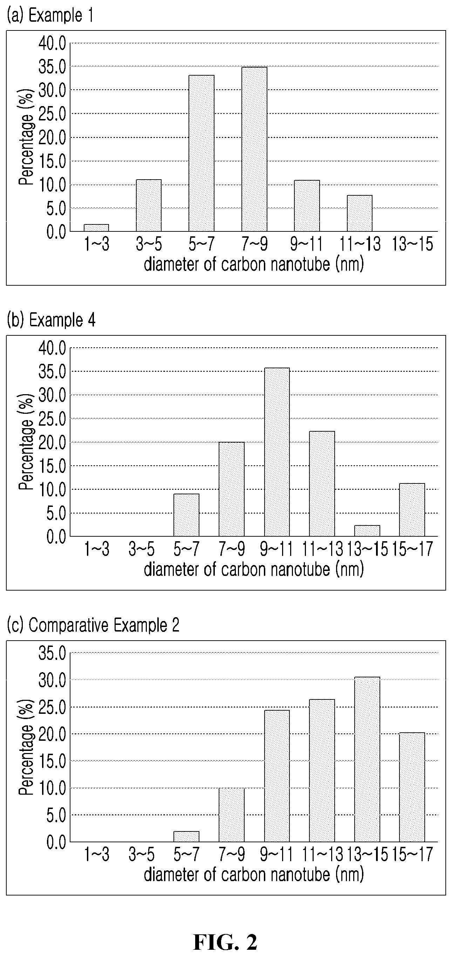

3) Average diameter: The average diameter was measured at 200,000x magnification using TEM (JEOL, JEM-2100F). Figs. 1 and 2 illustrate the TEM images of carbon nanotubes synthesized according to Examples 1 and 4, and Comparative Example 2, and the results of analyzing the diameter.
4) Bundle length: The bundle length was measured at 700x magnification using FE-SEM (JEOL, JSM-7500F).

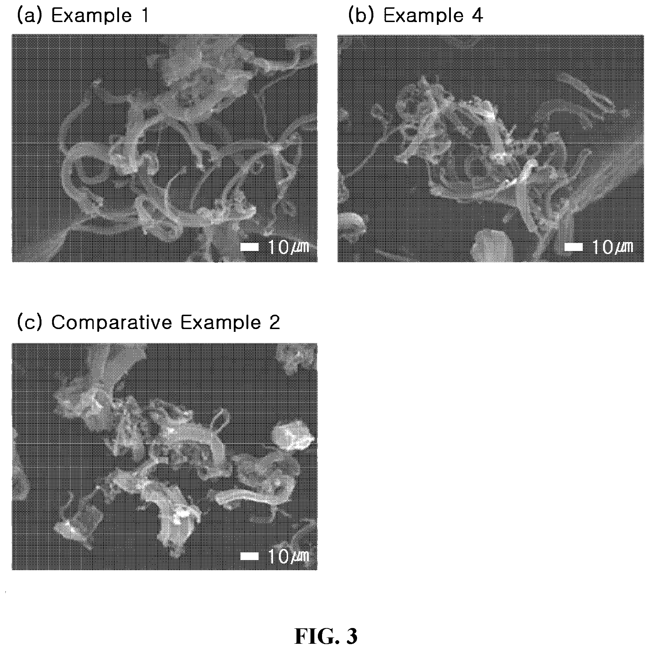

Fig. 3 illustrates the SEM image of carbon nanotubes synthesized according to Examples 1 and 4, and Comparative Example 2.
5) Bulk density: A 100 ml container with a known weight was filled with catalyst powder and weighed, and then the bulk density was converted according to the following equation.

$$\text{Bulk density} = \text{total amount (g) of synthesized carbon nanotubes/volume (ml) of}$$

$$\text{synthesized carbon nanotubes}$$

6) BET specific surface area: The BET specific surface area was measured using TriStar II 3020 equipment (Micrometrics).

[Table 2]

|  | Catalyst yield (%) | Purity (%) | Average diameter (nm) | Bundle length ($\mu$m) | Bulk density (g/ml) | BET specific surface area (m$^2$/g) |
|---|---|---|---|---|---|---|
| Example 1 | 1,087 | 90.80 | 7.3 | 69 | 0.009 | 348 |
| Example 2 | 1,142 | 91.24 | 8.2 | 60 | 0.01 | 334 |
| Example 3 | 1,273 | 92.14 | 8.6 | 59 | 0.013 | 328 |
| Example 4 | 1,343 | 92.55 | 10.3 | 55 | 0.015 | 312 |
| Example 5 | 1,027 | 90.26 | 7.4 | 87 | 0.009 | 357 |
| Example 6 | 1,196 | 91.64 | 8.1 | 72 | 0.012 | 331 |
| Example 7 | 1,353 | 92.61 | 9.4 | 54 | 0.028 | 283 |
| Comparative Example 1 | not synthesized | - | - | - | - | - |
| Comparative Example 2 | 1,398 | 92.85 | 12.7 | 49 | 0.017 | 295 |
| Comparative Example 3 | 1,410 | 92.91 | 12.3 | 43 | 0.036 | 261 |

Referring to Table 2 above, the carbon nanotube synthesized according to Examples 1 to 7 exhibited a high catalyst yield and purity while having a reduced diameter of 7 to 12 nm. Additionally, it was confirmed that as the ratio of the flow rate (a/b value) of carbon source gas to the input of catalyst decreases, the carbon nanotube synthesized has a smaller diameter.

As the a/b value decreases, the value of BET specific surface area increases. Generally, since it is known that carbon nanotubes have a higher specific surface area as they have a smaller diameter, it can be confirmed from the increased value of specific surface area that the diameter of carbon nanotubes decreases.

This result was obtained by controlling the ratio between the flow rate of carbon source gas and the input of catalyst to control catalytic activity. As the ratio of the flow rate of carbon source gas and the input of catalyst decreases, the catalytic activity decreases, and accordingly, low-diameter carbon nanotubes may be synthesized.

It was confirmed that as the a/b value decreases, the catalytic activity decreases, and accordingly, the carbon nanotube has a longer bundle length. Additionally, it was confirmed that as the synthesized carbon nanotube has a smaller diameter and a longer length, bulk density decreases.

In the synthesizing method according to Comparative Example 1, the a/b value is less than 0.1 L/g·min. As the catalytic activity was excessively low, carbon nanotubes were not synthesized.

In the synthesizing methods according to Comparative Examples 2 and 3, the a/b value exceeds 1.1 L/g min. As the catalytic activity was excessively high, the synthesis of carbon nanotubes rapidly proceeded, and carbon nanotubes with a diameter exceeding 12 nm were synthesized. Additionally, as the diameter increased, the value of specific surface area decreased, and due to the excessively high catalytic activity, short carbon nanotubes were synthesized. Also, due to the great diameter and short length, the bulk density tended to increase.

Experimental Example 2

In order to evaluate the electrical conductivity of the carbon nanotube synthesized according to Examples and Comparative Examples described above, the surface resistance and viscosity of the carbon nanotube were measured, and results thereof were shown in Table 3 below.

The dispersion of carbon nanotubes was evaluated by adding 0.5% of carbon nanotube and 0.25% of polyvinylpyrrolidone (PVP) as a dispersant to 100 ml of N-methylpyrrolidone (NMP) using an ultrasonic equipment (SONICS & MATERIALS, VC750). When preparing the dispersion, ultrasonic processing was performed for 20 minutes to complete the preparation of the dispersion.

The surface resistance of the carbon nanotube was measured using a 4-point probe after bar coating.

The viscosity was measured using a portable viscometer (Hydramotion, Viscolite 700).

[Table 3]

|  | Surface resistance ($\Omega$/sq) | Viscosity (cps) |
|---|---|---|
| Example 1 | $8.3 \times 10^3$ | 7.7 |
| Example 2 | $10.8 \times 10^3$ | 7.1 |
| Example 4 | $11.4 \times 10^3$ | 6.9 |
| Comparative Example 2 | $14.2 \times 10^3$ | 7.5 |

Referring to Table 3 above, the carbon nanotube synthesized according to Examples 1, 2 and 4 had low surface resistance and thus exhibited excellent electrical conductivity. It was confirmed that coating electrical conductivity improved as the carbon nanotube has a smaller diameter.

It was confirmed that the carbon nanotube synthesized according to Comparative Example 2 had higher surface resistance than those of the Examples, and thus had decreased electrical conductivity.

The foregoing description of the present specification has been presented for illustrative purposes, and it is apparent to a person having ordinary skill in the art that the present specification can be easily modified into other detailed forms without changing the technical idea or essential features of the present specification. Therefore, it should be understood that the forgoing embodiments are by way of example only, and are not intended to limit the present specification. For example, each component which has been described as a unitary part can be implemented as distributed parts. Likewise, each component which has been described as distributed parts can also be implemented as a combined part.

The scope of the present specification is presented by the accompanying claims, and it should be understood that all changes or modifications derived from the definitions and scopes of the claims fall within the scope of the present specification.

**Claims**

1. A method for preparing a carbon nanotube, the method comprising:

   (a) introducing a catalyst into a chemical vapor deposition reactor; and
   (b) injecting a carbon source gas to synthesize a carbon nanotube,

   wherein an input of the catalyst and a flow rate of the carbon source gas satisfy the following Formula 1:

   [Formula 1]

   $$0.1\ \mathrm{L/g\cdot min} \leq a/b \leq 1.1\ \mathrm{L/g\cdot min}$$

   wherein a represents a flow rate (L/min) of the carbon source gas and b represents an input (g) of the catalyst.

2. The method of claim 1, wherein the catalyst comprises a main catalyst and a support, wherein a mole fraction of the main catalyst to the support is 0.01 to 0.5.

3. The method of claim 1 or 2, wherein the catalyst comprises: i) one main catalyst selected from the group consisting of Co, Fe, Ni and combinations thereof; ii) one support selected from the group consisting of Al, Ca, Mg and combinations thereof; and iii) one cocatalyst selected from the group consisting of V, Mn, Mo and combinations thereof.

4. The method of one of claims 1 to 3, wherein the carbon source gas comprises one selected from the group consisting of unsaturated or saturated hydrocarbon having 1 to 4 carbon atoms, carbon monoxide and mixtures of two or more thereof.

5. A carbon nanotube prepared by the method of any one of claims 1 to 4.

6. The carbon nanotube of claim 5, wherein the carbon nanotube has a diameter of 7 to 12 nm.

7. The carbon nanotube of claim 5 or 6, wherein the carbon nanotube has a purity of 90% or more.

8. The carbon nanotube of one of claims 5 to 7, wherein the carbon nanotube has a bundle length of 50 to 200 $\mu$m.

9. The carbon nanotube of one of claims 5 to 8, wherein the carbon nanotube has a BET specific surface area of 250 to 400 $m^2$/g.

10. The carbon nanotube of one of claims 5 to 9, wherein the carbon nanotube has a bulk density of 0.005 to 0.5 g/ml.

(a) Example 1

(b) Example 4

(c) Comparative Example 2

**FIG. 1**

(a) Example 1

(b) Example 4

(c) Comparative Example 2

**FIG. 2**

(a) Example 1

(b) Example 4

(c) Comparative Example 2

**FIG. 3**

Europäisches
Patentamt

European
Patent Office

Office européen
des brevets

# EUROPEAN SEARCH REPORT

Application Number

EP 23 20 5035

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/207026 A1 (KIM DONG HWAN [KR] ET AL) 15 August 2013 (2013-08-15) * examples 2-5; tables 1-3 * * the whole document * ----- | 1-10 | INV. C01B32/162 B01J23/74 B01J23/84 H01M10/00 |
| X | US 2020/339421 A1 (SHIMIZU TOSHIAKI [JP] ET AL) 29 October 2020 (2020-10-29) | 5-10 | |
| A | * paragraph [0127] * * the whole document * ----- | 1-4 | |
| X | EP 3 301 745 A1 (LG CHEMICAL LTD [KR]) 4 April 2018 (2018-04-04) | 5-10 | |
| A | * table 2 * * the whole document * ----- | 1-4 | |

TECHNICAL FIELDS
SEARCHED      (IPC)

C01B
B01J
H01M

The present search report has been drawn up for all claims

| Place of search | Date of completion of the search | Examiner |
|---|---|---|
| The Hague | 7 March 2024 | Follens, Lana |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**EP 4 361 099 A1**

## ANNEX TO THE EUROPEAN SEARCH REPORT
## ON EUROPEAN PATENT APPLICATION NO.

EP 23 20 5035

07-03-2024

| Patent document cited in search report | | Publication date | Patent family member(s) | | Publication date |
|---|---|---|---|---|---|
| US 2013207026 | A1 | 15-08-2013 | JP | 5634543 B2 | 03-12-2014 |
| | | | JP | 2013163635 A | 22-08-2013 |
| | | | KR | 20130094364 A | 26-08-2013 |
| | | | US | 2013207026 A1 | 15-08-2013 |
| US 2020339421 | A1 | 29-10-2020 | JP | 7272855 B2 | 12-05-2023 |
| | | | JP | 2020180028 A | 05-11-2020 |
| | | | US | 2020339421 A1 | 29-10-2020 |
| EP 3301745 | A1 | 04-04-2018 | CN | 107851801 A | 27-03-2018 |
| | | | EP | 3301745 A1 | 04-04-2018 |
| | | | JP | 6749703 B2 | 02-09-2020 |
| | | | JP | 2018534747 A | 22-11-2018 |
| | | | KR | 20170049459 A | 10-05-2017 |
| | | | PL | 3301745 T3 | 31-01-2020 |
| | | | US | 2018198129 A1 | 12-07-2018 |

EPO FORM P0459